**Europäisches Patentamt**

**European Patent Office**

**Office européen des brevets**

(11) Veröffentlichungsnummer: **0 446 642 A1**

## (12) EUROPÄISCHE PATENTANMELDUNG

(21) Anmeldenummer: **91102136.8**

(22) Anmeldetag: **15.02.91**

(51) Int. Cl.⁵: **H03K 17/96, H05B 3/74**

(30) Priorität: **13.03.90 DE 4007971**

(43) Veröffentlichungstag der Anmeldung:
**18.09.91 Patentblatt 91/38**

(84) Benannte Vertragsstaaten:
**AT CH DE ES FR GB IT LI NL SE**

(71) Anmelder: **Gaggenau-Werke Haus- und Lufttechnik GmbH.**
**Eisenwerkstrasse 11**
**W-7560 Gaggenau(DE)**

(72) Erfinder: **von Blanquet, Georg**
**Annabergstrasse 7**
**W-7570 Baden-Baden(DE)**

(74) Vertreter: **Lempert, Jost, Dipl.-Phys. Dr. et al**
**Patentanwälte Dipl.-Ing. Heiner Lichti**
**Dipl.-Phys. Dr. Jost Lempert Durlacher**
**Strasse 31 Postfach 410760**
**W-7500 Karlsruhe 41(DE)**

(54) **Vorrichtung zum Schalten elektrischer Einrichtungen.**

㊷ Es wird eine Vorrichtung zum Schalten elektronischer Einrichtungen, insbesondere von Kochfeldern oder dergleichen vorgeschlagen, die dadurch gekennzeichnet ist, daß ein Lichtsender (2) und ein Lichtempfänger (3) unter einem im Transmissionswellenbereich des Lichtsenders hinreichend transparenten Platte (4) angeordnet sind.

Fig. 1

Die Erfindung betrifft eine Vorrichtung zum Schalten elektrischer Einrichtungen, insbesondere von Kochfeldern oder dergleichen. Sie betrifft weiterhin ein Verfahren zur Beaufschlagung einer derartigen Schaltvorrichtung.

Die Erfindung bezieht sich insbesondere auf das Schalten elektrischer Heizeinrichtungen, wie vor allem Kochfeldern oder Kochplatten an einem elektrischen Herd. Es sind herkömmliche elektromechanische Schalteinrichtungen, beispielsweise in Form von Knöpfen bekannt, mit denen elektrische Kontakte hergestellt bzw. geöffnet werden können. Derartige Schaltknöpfe sind bei Kocheinrichtungen mit durchgehenden Plattenabdeckungen, wie Abdeckungen aus Keramikplatten, ungünstig, weil sie die gewünschte ebene Plattenoberfläche, die leicht zu reinigen ist, in störender Weise unterbrechen und insbesondere dort Schmutzfänger bilden können. Zur Vermeidung dieses Nachteils können an sich grundsätzlich berührungslose kapazitive Schalteinrichtungen vorgesehen werden. Deren Schaltvermögen ist aber in erheblichem Maße feuchtigkeitsabhängig. Es kann nicht verhindert werden, daß die Oberfläche einer solchen Schalteinrichtung im Küchenbereich, in dem Dämpfe durch den Kochvorgang entstehen, feucht wird, wodurch ein Schaltvorgang beeinflußt werden kann. Darüberhinaus kann auch die kapazitive Anordnung nicht vollständig feuchtigkeitsdicht eingedichtet sein, da eine solche Eindichtung die Wärmeableitung im Bereich der Schaltanordnung verschlechtern würde, die bei elektrischen Kocheinrichtungen aufgrund der dort erzeugten Wärme notwendig ist. Das heißt, daß auch in dem Bereich der eigentlichen Schalteinrichtung Feuchtigkeit eindringen kann, die das Schaltvermögen einer solchen kapazitiven Schalteinrichtung beeinflußt.

Der Erfindung liegt daher die Aufgabe zugrunde, unter Vermeidung der vorgenannten Nachteile eine verbesserte Vorrichtung zum Schaltung elektrischer Einrichtungen, wie insbesondere Heiz- oder Kocheinrichtungen zu schaffen.

Erfindungsgemäß wird die genannte Aufgabe mit einer Vorrichtung der eingangs genannten Art gelöst, welche dadurch gekennzeichnet ist, daß ein Lichtsender und ein Lichtempfänger unter einer im Transmissionswellenbereich des Lichtsenders hinreichend transparenten Platte angeordnet sind.

Durch die Erfindung wird eine berührungs- und kontaktfreie Schaltvorrichtung geschaffen, die robust ausgebildet werden kann und im rauhen Alltag bei Koch- und Heizeinrichtungen keinen Beeinträchtigungen unterliegt. Insbesondere ist sie unempfindlich gegen Umgebungseinflüsse, wie Kochdämpfe, die kondensieren, Feuchtigkeit oder dergleichen. Auch kann die im interessierenden Lichtwellenbereich, als welcher vorzugsweise ein Infrarotbereich von 900 bis 1000 nm gewählt wird, hinreichend transparente Platte - vorzugsweise aus Glaswerkstoff, wie Glaskeramik - in einer solchen Stärke gewählt werden, daß sie sicher und zuverlässig Abdeckungsschutz von Lichtsender und -empfänger gewährleistet.

In bevorzugter Ausgestaltung ist, wie angedeutet, vorgesehen, daß der Sender eine Infrarotdiode ist und daß der Lichtempfänger ein im infraroten Bereich empfindlicher Detektor ist. Als Platte aus Glaswerkstoff wird vorzugsweise eine Glaskeramikplatte eingesetzt, die beispielsweise eine Stärke von 4 mm aufweisen kann. Sie weist insbesondere in dem hier interessierenden Wellenlängenbereich der Infrarotstrahlung eine hinreichende bzw. noch gute Durchlässigkeit auf, während ihre Durchlässigkeit in wünschenswerter Weise zum sichtbaren Licht hin abfällt, so daß sie insofern erste Filterwirkungen zum Ausfiltern von störendem Umgebungslicht erfüllen kann. Darüberhinaus kann vorgesehen sein, daß vor dem Empfänger selbst ein weiteres selektives optisches Filter vorgesehen ist, das nur den interessierenden Wellenlängenbereich durchläßt, andere Wellenlängenbereiche, insbesondere sichtbares Licht, vor allem auch rotes sichtbares Licht demgegenüber ausblendet.

In bevorzugter Weiterbildung kann vorgesehen sein, daß die Unterseite der Platte mit einer dünnen Siliconschicht versehen ist, die im infraroten Bereich hinreichend durchlässig ist. Hierdurch ergibt sich zunächst die Möglichkeit, daß Lichtsender und -empfänger mittels Silicon an der Unterseite der Platte befestigt sind. Vor allem aber weisen insbesondere Glaskeramikplatten, soweit es sich nicht um Sonderanfertigungen handelt, in der Regel eine aufgerauhte Unterfläche auf, die durch die Siliconschicht eingeebnet werden kann. Wenn das Silicon einen Brechungsindex im Bereich des Brechungsindexes der Abdeckplatte aufweist, bei Glaskeramik beispielsweise von 1,6, so reicht es, wenn das Silicon auf der rauhen Unterfläche der Platte nur in die Vertiefungen eingebracht wird und bündig mit den höchsten Erhöhungen abschließt. Durch diese Ausgestaltung kann gegenüber Sonderanfertigungen preiswertere herkömmliche Serienglaskeramik eingesetzt werden. Es hat sich herausgestellt, daß nicht eingefärbtes Silicon in dem hier interessierenden Wellenlängenbereich der Infrarotstrahlung ebenfalls eine ausreichende Durchlässigkeit aufweist. Während als Glaskeramik insbesondere Ceran der Fa. Schott, Mainz eingesetzt wird, kann als Silicon mit den gewünschten Eigenschaften das Material Elastosil E 43 transparent der Fa. Wacker vorzugsweise verwendet werden.

In äußerst bevorzugter Ausgestaltung kann die durch Lichtsender und -empfänger sowie Abdeckplatte gebildete Reflexlichtschranke im Rahmen der Erfindung mit einer Leuchtanzeigeeinheit, wie einer LED-Anzeige, insbesondere in 7-Segment-Form kombiniert werden. In diesem Fall ist in bevorzugter Weise vorgesehen, daß Lichtsender und -empfänger derart ausgerichtet sind, daß ihre optischen Achsen sich über der Leuchtanzeigeeinheit treffen. Um eine weiter gesteigerte Selectivität der erfindungsgemäßen Schaltvorrichtung zu erreichen, insbesondere bei einer Kombination mit LED-Anzeigen, die in der Regel rot leuchten und darüberhinaus auch im Infrarotanteil eine noch zu berücksichtigende Leuchtstärke aufweisen, kann eine weitere elektronische Filterung einerseits durch einen als Hochpass dienenden Kondensator vorgesehen sein. Darüberhinaus kann auch ein Bandpass vorgesehen sein. Eine bevorzugte Weiterbildung sieht eine digitale Filterung vor.

Um die erfindungsgemäße Schaltvorrichtung optimal einsetzen zu können, wird weiterhin erfindungsgemäß ein Verfahren zur Beaufschlagung einer derartigen optischen Schaltvorrichtung vorgesehen, bei dem Lichtsender und -empfänger gepulst bzw. getaktet werden. Da am herkömmlichen Versorgungsnetz angeschlossene Glühlampen einen dieser Netzfrequenz entsprechenden Wechsellichtanteil, also beispielsweise von 50 Hz aufweisen und Leuchtstoff- bzw. Neonröhren mit einer Frequenz von 100 Hz beaufschlagt werden, ist in bevorzugter Ausgestaltung vorgesehen, daß der Sender mit einer Puls- bzw. Taktfrequenz ungleich einem Vielfachen der Netz- bzw. Leuchtstoffröhrenfrequenz beaufschlagt wird. Vorzugsweise kann eine Frequenz im Bereich von mehreren 100 Hz, beispielsweise von 660 Hz eingesetzt werden. Soweit LED-Anzeigen vorgesehen sind und diese im Multiplex-Verfahren angesteuert werden, sieht eine bevorzugte Weiterbildung vor, daß die Anzeigen lediglich in den Taktpausen der Lichtsender multiplex betrieben werden.

Während grundsätzlich die Abdeckplatte der erfindungsgemäßen Vorrichtung eine für diese Eigene sein kann, kann hierfür auch die herkömmliche Keramikplatte von Keramikkochfeldern verwendet werden, die demgemäß gleichzeitig (Infrarot-)Lichtsender und Lichtempfänger und Kochplatten abdeckt.

Weitere Vorteile und Merkmale der Erfindung ergeben sich aus den Ansprüchen und aus der nachfolgenden Beschreibung, in der ein Ausführungsbeispiel der Erfindung unter Bezugnahme auf die Zeichnung im einzelnen erläutert ist. Dabei zeigt:

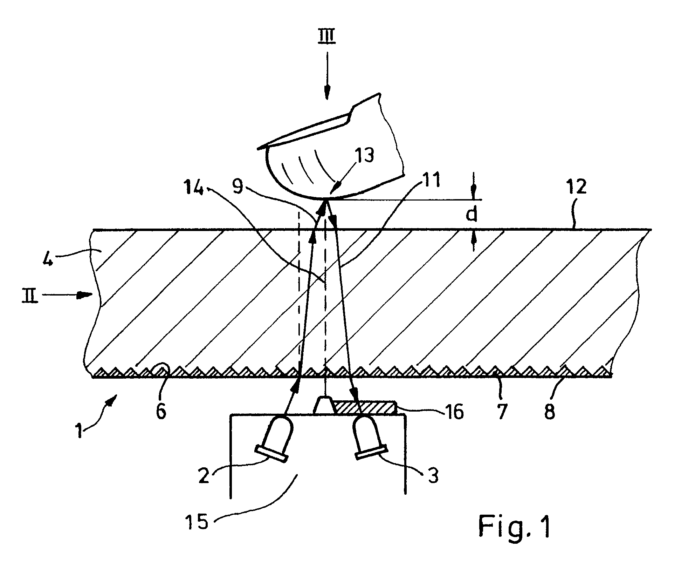

Figur 1    eine Schnittdarstellung der erfindungsgemäßen Schaltvorrichtung;

Figur 2    eine Sicht entsprechend II-II der Fig.1;

Figur 3    eine Aufsicht auf die Schaltvorrichtung der Figuren 1 und 2 entsprechend der dortigen Pfeile III;

Figur 4    ein Ausschnitt der Schaltung der erfindungsgemäßen Vorrichtung; und

Figur 5    Taktverhältnisse Anzeige/IRED.

Die erfindungsgemäße Schaltvorrichtung 1 weist einen Lichtsender 2 auf, unmittelbar neben dem ein Lichtempfänger 3 angeordnet ist. Lichtsender und Lichtempfänger 2, 3 sind unter einer Platte 4 aus Glaswerkstoff, hier Glaskeramik, wie von der Fa. Schott, Mainz vertriebenes Ceran, angeordnet. Soweit die Glaskeramikplatte 4 rückseitig Rauhigkeiten 6 aufweist ist sie mit einer dünnen Siliconschicht 7 versehen, deren freie Oberfläche 8 glatt ist. Sender 2 und Empfänger 3 sind derart zueinander geneigt, daß der Mittenstrahl 9 des Senders 2 als Mittenstrahl 11 auf den Empfänger 3 trifft, wenn er in sehr geringem Abstand d oberhalb der Sender 2 und Empfänger 3 abgewandten Oberfläche 12 der Platte 4 in einem Punkt 13 zurückreflektiert wird, durch den eine zur Plattenoberfläche 12 senkrechte Mittelebene 14 geht.

Der Lichtsender 2 ist im dargestellten Ausführungsbeispiel eine Infrarot-Leuchtdiode, die eine maximale Intensität im Bereich von 950 mm erarbeitet. Demgemäß wird ein Lichtempfänger verwendet, der ebenfalls im Bereich von 900 bis 1000 nm eine hohe Empfindlichkeit hat, wie eine Infrarot-Fotodiode oder ein Infrarot-Fotodetektor. Zur Verbesserung der spektralen Empfindlichkeit der gesamten Anordnung trägt bei, daß auch die Glaskeramikplatten eine maximale Durchlässigkeit im Bereich von 700 bis 950 nm haben, also in dem Bereich, in dem der Fotoempfänger eine hohe Empfindlichkeit hat, während sie im sichtbaren Bereich eine geringere Durchlässigkeit haben, und damit diesen Bereich ausfiltern. Die verwendete Siliconschicht soll einerseits ebenfalls eine gute Lichtdurchlässigkeit, vorzugsweise im Infrarotbereich aufweisen und andererseits einen Brechungsindex haben, der im Bereich des der Glaskeramik von 1,6 liegt. Diese Eigenschaften werden durch ein Silikon, wie es von der Fa. Wacker unter der Bezeichnung "Elastosil E 43" transparent vertrieben wird, hinreichend erfüllt. Die Glaskeramikplatte wird vorzugsweise und in der Regel in einer Stärke von etwa 4 mm eingesetzt. Hierbei weist sie einerseits eine hohe Festigkeit auf, wie sie für den beabsichtigten Einsatzzweck im Küchenbereich erforderlich ist, andererseits auch noch eine hinreichende Durchlässigkeit für das eingesetzte Infrarotlicht. Zusätzlich kann unmittelbar über den Lichtempfänger 3 eine optische Filterplatte 16 angeordnet sein, die eine weitere optische Filterung bewirkt.

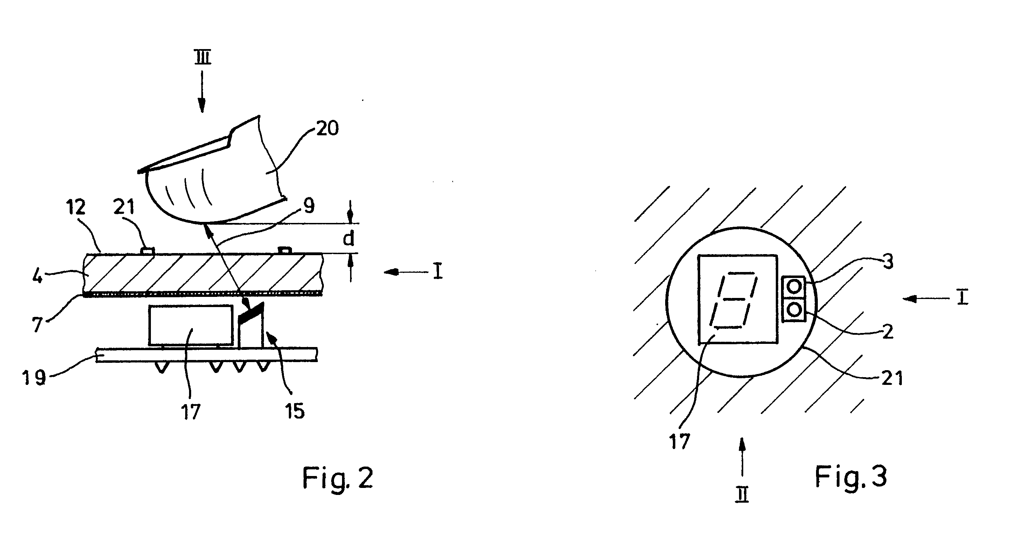

Wie den Figuren 2 und 3 zu entnehmen ist, ist unmittelbar neben der aus Lichtsender 2 und Lichtempfänger 3 gebildeten Reflexlichtschranke 15 eine Anzeigeeinheit 17 in Form einer LED-Anzeige, wie einer 7-Segment-Anzeige angeordnet. Da der Benutzer durch die Glaskeramikplatte 4 hindurch die Reflexlichtschranke 15 selbst nicht sieht, aber die Leuchtanzeige 17 erkennen kann, sind Lichtsender 2 und Lichtempfänger 3 derart geneigt zur Platte 4 angeordnet, daß der Mittenstrahl 9 senkrecht oberhalb der Anzeige 17 aus der Platte 4 austritt und in einem geringen Abstand d oberhalb der Oberfläche 12 der Platte 4 auf einen dort befindlichen Schaltfinger 20, der einen Schaltvorgang ausübt, auftrifft und von diesem reflektiert wird. Es ist dabei darauf hinzuweisen, daß der Finger das auf ihn auftreffende Licht nicht spiegelreflektiert, sondern diffus reflektiert bzw. diffus zurückstreut, so daß trotz der gewählten optischen Anordnung noch hinreichend vom Finger 20 zurückgestreutes Licht auf den Lichtempfänger 3 trifft. Die Leuchtanzeigeeinheit 17 sowie die Reflexlichtschranke 15 können gemeinsam auf einer Leiterplatte 19 angeordnet und unter der Platte 4 gehalten sein. Grundsätzlich ist es auch möglich, die Lichtschranke 15 durch das für die Schicht 7 verwendete Silicon an der Platte 4 zu befestigen.

Es kann weiterhin vorgesehen sein, daß die Anordnung von Lichtschranke 15 und Leuchtanzeigeeinheit 17 auf der Oberseite 12 der Platte 4 durch eine Markierung 21 gekennzeichnet ist, wie einen eingravierten oder aufgedruckten Ring.

Der Lichtsender 2 wird durch einen Puls- oder Taktgeber 31 beaufschlagt, der den Lichtsender mit relativ hohen Stromimpulsen, wie bis zu 100 mA, ansteuert. Dem Lichtempfänger 3 ist einerseits zur Gleichspannungsentkopplung ein Kondensator 32 nachgeordnet sowie weiterhin ein Komparator 33, der das Grundrauschen und eine Restkopplung beseitigt sowie die empfangenen Impulse auf einen für die elektronische Weiterverarbeitung, wie durch CMOS-Elektronik, erforderlichen Pegel anhebt.

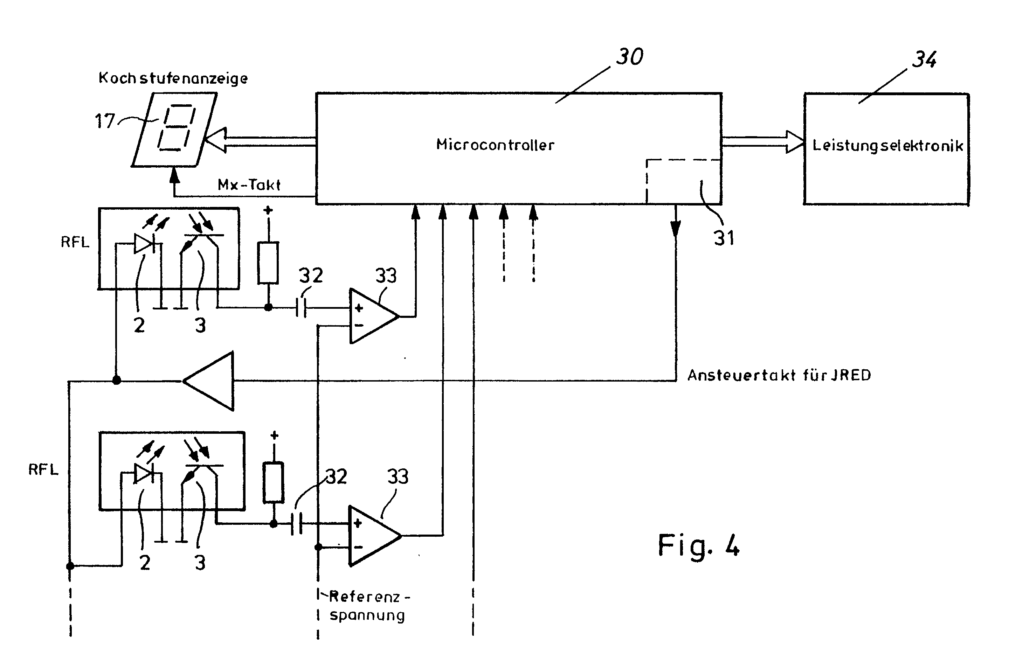

Der Lichtsender 2 (infrarotemittierende Diode - IRED) wird durch einen Puls- oder Taktgeber 31 als Teil eines Mikrokontrollers 30 beaufschlagt, der den Lichtsender 2 in einem Ansteuertakt mit relativ hohen Stromimpulsen, wie bis zu 100 mA, ansteuert. Dem Lichtempfänger 3 der Reflektionslichtschranken (RFL) ist zunächst zur Gleichspannungsentkopplung ein Kondensator 32 nachgeordnet sowie weiterhin ein Komparator 33, der das Grundrauschen und eine Restkopplung - durch Vergleich mit einer Referenzspannung - beseitig. Im übrigen werden die empfangenen Impulse gegebenenfalls auf einen für die elektronische Weiterverarbeitung, wie durch eine C-Mos-Elektronik, erforderlichen Pegel angehoben. Der Mikrokontroller 30 steuert weiterhin die Kochstufenanzeige 17, gegebenenfalls im Multiplex sowie aufgrund der durch die Reflektionslichtschranken empfangenen Schaltinformationen,eine Leistungselektronik 34 für die entsprechenden Kochfelder (in Figur 4 nicht dargestellt).

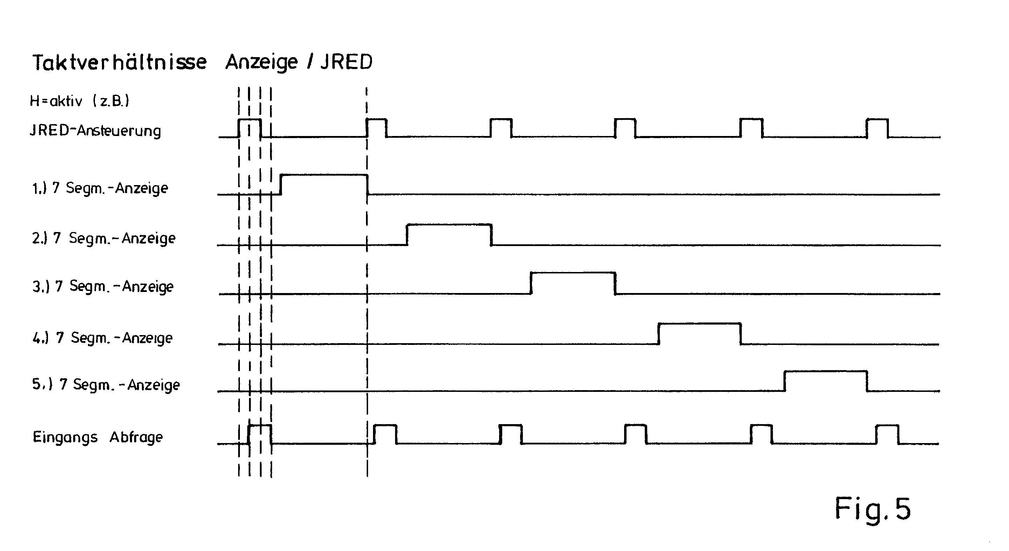

Die vom Pulsgeber 31 bewirkte Pulsfrequenz wird derart gewählt, daß sie ungleich der Netzfrequenz sowie der Frequenz mit solcher betriebenen Leuchtstoffröhren (100 Hz bei 50 Hz Netzfrequenz) und deren Oberwellen liegt. Eine Frequenz von 660 Hz hat sich hier als geeignet herausgestellt. Um Wechselwirkungen zu vermeiden, da die üblicherweise im Rotlichtbereich strahlenden LED's durchaus noch Infrarotanteile haben, wird der Lichtsender in Impulspausen des Multiplexens der Anzeigeeinrichtung 17 beaufschlagt. Der Lichtempfänger wird ebenfalls mit dem Takt des Lichtsenders 2 angesteuert, d.h. bei den diesen ansteuernden Impulsen geöffnet und in den Impulspausen geschlossen (siehe Figur 5).

Die vom Lichtsender 2 ausgesandte Infrarotstrahlung tritt durch die Siliconschicht 7 und durch die Glaskeramikplatte 4 hindurch. Wird zum Schalten ein Finger im Bereich der Austrittsstelle des Strahls 9 über der Oberfläche 12 der Glaskeramikplatte 4 gehalten, so streut der Finger 20 das Licht. Das Licht tritt wiederum durch die Glaskeramikplatte 4 und die Siliconschicht sowie zu einem hinreichenden Anteil durch den über dem Empfänger 3 angeordneten Filter 16 in den Empfänger 3, wodurch ein Schaltvorgang, wie ein Ein- oder Ausschalten eines Kochfeldes oder einer Kochplatte oder dergleichen bewirkt werden kann, wobei die Leistungsversorgung des Kochfeldes oder der Kochplatte vorzugsweise durch den Ausgang der dem Lichtempfänger 3 nachgeordneten Steuerelektronik durch einen Optokoppler angesteuert wird. Während, wie dargelegt, einerseits trotz der schwierigen Einsatzbedingungen eine hinreichende Intensität und ein möglichst gutes Signal-Rauschverhältnis durch die Wahl der Lichtwellenlänge im infraroten Bereich erzielt wird, in der die Glaskeramikplatte gegenüber dem sichtbaren Bereich eine höhere Durchlässigkeit aufweist und darüberhinaus ein zusätzlicher Filter 16 vorgesehen ist, erfolgt eine weitere Signalverbesserung in elektronischer Weise. Hierzu wird, wie gesagt, der Lichtsender 2 mit Impulsen relativ hohen Stromes beaufschlagt, wobei die Impulsfrequenz außerhalb der genannten Störeinflüsse liegt und ebenfalls der Empfänger nur bei Anlegen von Pulsen aufgesteuert wird. Gleichzeitig werden Gleichstromanteile durch den als Hochpass wirkenden Kondensator eliminiert.

**Patentansprüche**

1. Vorrichtung zum Schalten elektronischer Einrichtungen, insbesondere von Kochfeldern oder dergleichen, dadurch gekennzeichnet, daß ein Lichtsender (2) und ein Lichtempfänger (3) unter einer im Transmissionswellenbereich des Lichtsenders hinreichend transparenten Platte (4) angeordnet sind.

2. Vorrichtung nach Anspruch 1, dadurch gekennzeichnet, daß der Sender (2) eine Infrarotdiode ist.

3. Vorrichtung nach Anspruch 2, dadurch gekennzeichnet, daß der Lichtempfänger ein im infraroten Bereich empfindlicher Detektor ist.

4. Vorrichtung nach einem der Ansprüche 1 bis 3, dadurch gekennzeichnet, daß die Platte (4) aus Glaskeramik besteht.

5. Vorrichtung nach einem der Ansprüche 1 bis 4, dadurch gekennzeichnet, daß die Unterseite der Platte (4) mit einer dünnen Siliconschicht versehen ist.

6. Vorrichtung nach Anspruch 5, dadurch gekennzeichnet, daß die Siliconschicht einen Brechungsindex im Bereich des Brechungsindexes der Platte (4) aufweist.

7. Vorrichtung nach einem der Ansprüche 1 bis 6, dadurch gekennzeichnet, daß Lichtsender und -empfänger mittels Silicon an der Unterseite der Platte (4) befestigt sind.

8. Vorrichtung nach einem der Ansprüche 1 bis 7, dadurch gekennzeichnet, daß zwischen oder unmittelbar neben Lichtsender und -empfänger (2, 3) eine Leuchtanzeigeeinheit (17) angeordnet ist.

9. Vorrichtung nach Anspruch 8, dadurch gekennzeichnet, daß Lichtsender und -empfänger (2, 3) derart ausgerichtet sind, daß ihre optischen Achsen sich über der Leuchtanzeigeeinheit (17) treffen.

10. Vorrichtung nach einem der vorangehenden Ansprüche, dadurch gekennzeichnet, daß vor dem Lichtempfänger (3) ein optischer Filter mit maximalem Durchschlagsbereich im Bereich maximaler Empfindlichkeit des Lichtempfängers (3) angeordnet ist.

11. Vorrichtung nach einem der vorangehenden Ansprüche, dadurch gekennzeichnet, daß der Lichtsender (2) durch einen Impuls- oder Taktgeber (31) beaufschlagt ist.

12. Vorrichtung nach Anspruch 11, dadurch gekennzeichnet, daß dem Lichtempfänger ein durch den Taktgeber (31) angesteuertes Tor (Komparator 33) nachgeordnet ist.

13. Vorrichtung nach einem der vorangehenden Ansprüche, dadurch gekennzeichnet, daß dem Lichtempfänger ein Kondensator (32) als Hochpass nachgeschaltet ist.

14. Vorrichtung nach einem der Ansprüche 8 bis 13, dadurch gekennzeichnet, daß der Leuchtanzeigeeinheit eine Multiplex-Einrichtung zugeordnet ist.

15. Verfahren zur Beaufschlagung einer optischen Schaltvorrichtung nach einem der Ansprüche 1 bis 14, dadurch gekennzeichnet, daß Lichtsender und -empfänger (2, 3) gepulst bzw. getaktet werden.

16. Verfahren nach Anspruch 15, dadurch gekennzeichnet, daß Lichtsender und -empfänger mit einer Frequenz im Bereich von mehreren 100 Hz getaktet werden.

17. Verfahren nach Anspruch 15 oder 16, dadurch gekennzeichnet, daß mit einer Frequenz ungleich einem Vielfachen der Netzfrequenz sowie der durch diese bedingten Frequenz von Leuchtstoffröhren getaktet wird.

18. Verfahren nach einem der Ansprüche 15 bis 17, dadurch gekennzeichnet, daß die Pulsbeaufschlagung des Lichtsenders in Pausen einer Multiplexbeaufschlagung der Leuchtanzeigeeinheit erfolgt.

Fig. 1

EP 0 446 642 A1

Fig. 2

Fig. 3

EP 0 446 642 A1

Fig. 4

## Taktverhältnisse Anzeige / JRED

H=aktiv (z.B.)

JRED-Ansteuerung

1.) 7 Segm.-Anzeige

2.) 7 Segm.-Anzeige

3.) 7 Segm.-Anzeige

4.) 7 Segm.-Anzeige

5.) 7 Segm.-Anzeige

Eingangs Abfrage

Fig.5

EP 0 446 642 A1

**Europäisches Patentamt**

**EUROPÄISCHER RECHERCHENBERICHT**

Nummer der Anmeldung

EP 91102136.8

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl⁵) |
|---|---|---|---|
| X | WO - A1 - 86/01 953 (NOBBS, M., J.) * Zusammenfassung; Seite 5, Zeile 17 - Seite 6, Zeile 9; Anspruch 1; Fig. 2,5 * | 1-3 | H 03 K 17/96 H 05 B 3/74 |
| A | | 4,11, 15 | |
| X | FR - A1 - 2 621 192 (PERALES, M.) * Zusammenfassung; Ansprüche 1,2; Fig. 1,2 * | 1-3 | |
| A | | 4,11, 15 | |
| X | GB - A - 2 161 266 (A.C. IOANNIDIS) * Zusammenfassung; Seite 1, Zeile 86 - Seite 2, Zeile 9; Seite 2, Zeilen 44-72; Fig. 1,3 * | 1 | |
| A | | 3-4, 11,15 | RECHERCHIERTE SACHGEBIETE (Int. Cl⁵) |
| X | DE - B2 - 2 812 952 (OMRON TATEISI) * Spalte 3, Zeilen 11-34; Anspruch 1; Fig. 1 * | 1 | G 01 D 5/00 H 03 K 17/00 H 04 N 1/00 H 05 B 3/00 |
| A | | 3-4 | |
| A | DE - A1 - 3 422 120 (CANON) * Zusammenfassung; Seite 8, Zeile 32 - Seite 9, Zeile 7; Fig. 2 * | 1-4 | |
| A | GB - A - 2 130 363 (GULF APPLIED) * Zusammenfassung; Fig. 4 * | 1-4 | |

Der vorliegende Recherchenbericht wurde für alle Patentansprüche erstellt.

| Recherchenort | Abschlußdatum der Recherche | Prüfer |
|---|---|---|
| WIEN | 21-06-1991 | TSILIDIS |